# EUROPEAN PATENT APPLICATION

(11) **EP 4 224 190 A1**
(43) Date of publication of application: **09.08.2023**
(21) Application number: 22154773.0
(22) Date of filing: 02.02.2022
(51) Int. Cl.: G01R 33/30, G01R 33/34

(54) **IMPROVEMENTS IN MAS NMR**

(71) Applicant: ETH Zurich, 8092 Zurich (CH)
(72) Inventor: BARNES, Alexander, 8044 Zürich (CH); GAO, Chukun, 8046 Zürich (CH); CHEN, Pin-Hui, 8050 Zürich (CH)

(57) **Abstract**

A coil (1) for a probe head (2) of a magnetic resonance spectrometer comprising a rotor (3), is configured to transmit a radiofrequency signal in order to excite a sample being received in the rotor (3) and/or configured to receive a radiofrequency signal being emitted by the sample. The coil (1) comprises a plurality of turns (4, 4a, ...) that are arranged along a coil axis (C) extending along the coil (1) and that define an ellipsoid shape, preferably a spherical shape. A probe head (2) for a probe of a magnetic resonance spectrometer comprises a rotor (3), a rotation device (9) being configured to generate a rotation of the rotor (3), and a coil (1).The rotation device (9) comprises a fluid supply device (6) and/or a fluid directing device (10). The fluid supply device (6) comprises a plurality of fluid apertures (7, 7a, ...) being arranged in a common plane (P). The fluid directing device (10) comprises or consists of the coil (1).

## Description

### TECHNICAL FIELD

The present invention relates to a coil for a probe head of a magnetic resonance spectrometer and to probe heads for a probe of a magnetic resonance spectrometer.

### PRIOR ART

Magic angle spinning [1-3] (MAS) is necessary in solid state nuclear magnetic resonance (NMR) to obtain high-resolution spectra for characterizing the local chemical environment of biomolecular and inorganic solids [4-17]. Traditional MAS employees a cylindrical sample container rotating about an axis inclined at the magic angle, which is 54.74° with respect to the external magnetic field. A solenoid coil is wrapped tightly around the cylindrical rotor for optimal NMR sensitivity. However, to set up the magic angle, the rotor, coil and stator have to be oriented along the magic angle, resulting in only 80% usage of the radio frequency (RF) power. The stator assembly consists of -12 precisely machined components to house the rotor and supply bearing and drive gas streams, requiring large probe head space. Rotor wobbling during the spinning at high frequencies may cause rotor crash and stator damage.

In 2018 a new platform for MAS NMR was shown, where spherical rotors are spun within a semispherical stator cup and a single gas stream is used for both bearing and drive [18]. Spherical rotors exhibit exceptional rotation stability and resilience against crashing due to their symmetry axis being aligned with their axis of highest inertia [19]. The spherical geometry of the rotor and the single gas stream releases the space requirement on the probe head. Higher spinning frequency and RF fields have been achieved using smaller rotors [20, 21]. However, there is one big disadvantage of MAS spheres - much lower NMR filling factor compared to the cylindrical rotor. This is due to the small sample volume within the sphere and the large gap between RF coil and rotor. Efforts have been taken to improve the NMR filling factor. The four-turn split coil was replaced with a double saddle coil tightly wrapped around the stator cup [19-22]. The cylindrical sample chamber was expanded to hold more sample [18]. New stator design that replaces the stator cup wall with a saddle coil further increases the NMR sensitivity by three times [21].

However, there is still a general need to further improve the sensitivity in MAS NMR experiments while high-precision requirements associated with the manufacturing of the components are released.

### SUMMARY OF THE INVENTION

It is an object of the present invention to provide a coil for a probe head and a probe head for a magnetic resonance spectrometer that improve the sensitivity in NMR experiments.

This object is achieved by the coil according to claim 1 and the probe heads according to claims 4 and 7, respectively.

That is, in a first aspect a coil for a probe head of a magnetic resonance spectrometer comprising a rotor is provided. The coil is configured to transmit at least one radiofrequency signal in order to excite a sample being received in the rotor. Additionally or alternatively, the coil is configured to receive at least one radiofrequency signal being emitted by the sample in response to an excitation of the sample by a radio frequency signal. That is, the coil preferably corresponds to a radio frequency coil such as a transmit-receive coil capable of transmitting and receiving radiofrequency signals. The coil comprises a plurality of turns that are arranged along a coil axis extending along the coil. The plurality of turns of the coil define an ellipsoid shape, preferably a spherical shape.

The expression "defining an ellipsoid shape" is understood as the turns of the coil being arranged along the coil axis such, that a fictitious surface that envelopes the plurality of turns has the shape of an ellipsoid.

The turns of the coils can be designed and/or arranged such that different ellipsoid shapes are formed. For instance, the turns can be designed and/or arranged such that an ellipsoid shape in the form of a sphere or a spheroid such as an oblate spheroid or a prolate spheroid is formed.

To this end, it is particularly preferred that the ellipsoid shape has the shape of a sphere. In other words, it is particularly preferred that the plurality of turns of the coil define a spherical shape. Again in other words, the coil particularly preferably is a spherical coil.

That is, the shape of the coil does not correspond to a cylindrical shape as it is the case with the straight solenoid coils for cylindrical rotors known in the state of the art.

The ellipsoidal coil allows the coil axis to be aligned perpendicular to the direction of the external magnetic field in an NMR spectrometer regardless of the axis of rotation of the rotor. Consequently, if one is defining said direction of the external magnetic field as the z-axis, all of the magnetic field B1 being generated by radiofrequency pulses is generated along an x,y-plane being spanned by x- and y-axis running perpendicularly to the z-axis. As such, NMR experiments such as dynamic-angle spinning (DAS) and variable-angle spinning can be performed without compromising the B1 field, whereby the sensitivity is greatly improved.

Throughout this application, the expression spinning and rotating are used interchangeably. For instance, a spinning rotor corresponds to a rotating rotor and vice versa.

A circumference of the individual turns of the coil with respect to a circumferential direction of the turns is preferably elliptic, particularly preferably circular. That is to say, an individual turn preferably has an elliptic shape and particularly preferably a circular shape when the coil is seen in cross-section, i.e. when seen as a plane section at an angle of 90° with respect to the coil axis.

Moreover, the circumference of the individual turns with respect to the circumferential direction of the turns preferably varies with respect to the coil axis. That is to say, it is preferred that the turns extend at different distances from the coil axis. Again in other words, turns of different size such as smaller turns and larger turns are preferred.

With regard to an extension direction, which extends from a beginning of the coil being provided by a first turn of the coil to an end of the coil being provided by a last turn of the coil, the circumference of the turns preferably becomes increasingly larger and then increasingly smaller. That is, the circumference of the turns in the region of the beginning of the coil and the circumference of the turns in the region of the end of the coil is preferably smaller than the circumference of the turns in a middle region of the coil. That is, the circumference of the turn or turns in the middle region is particularly preferred largest.

A preferred extension of the coil along an axis extending through a center of the coil and along the coil axis preferably is between 1 millimeter to 20 millimeter, more preferably between 5 millimeter to 15 millimeter.

A preferred extension of the coil along an axis extending through the center of the coil and perpendicularly to the coil axis preferably is between 1 millimeter to 20 millimeter, more preferably between 5 millimeter to 15 millimeter.

In the event that the coil has the shape of a sphere said extensions can be seen as the coil diameter. That is, the coil diameter of the coil preferably is between 1 millimeter to 20 millimeter, more preferably between 5 millimeter to 15 millimeter.

That is, various extensions of the coil or coil diameters are conceivable, wherein the coil extension (diameter) preferably depends on a size of the rotor. In fact, it is preferred that the coil extension (diameter) is larger than a rotor diameter of the rotor. The coil extension (diameter) is particularly preferably between 0.001 millimeter to 15 millimeter, more preferably between 0.001 millimeter to 4 millimeter larger than the rotor diameter.

A distance between successive turns of the coil can remain constant or can vary with respect to the coil axis. In the latter case, as an example, it is preferred that the distance between successive turns of the coil is smaller in the middle region of the coil. That is, a higher number of turns is preferred in the middle region of the coil, whereas the number of turns is preferably sparser in the outer regions of the coil, i.e. in the region of the beginning and end of the coil.

Various number of turns are conceivable, wherein the number of turns preferably depend on a size of the rotor. A preferred number of turns is between 2 turns to 10 turns.

Moreover, in the event of a coil having turns of different size, it is preferred that the said coil diameter is defined by the largest turn, i.e. it is preferred that the said coil diameter corresponds to the diameter of the largest turn of the coil.

In addition, the coil, in particular its turns, is preferably formed by a wire. A wire diameter of the wire can remain constant or can vary with respect to the coil axis. A wire diameter of the wire is preferably between 0.0001 millimeter to 2 millimeter. Moreover, various distances between successive turns with respect to the coil axis are conceivable. For instance, a preferred distance between successive turns with respect to the coil axis is between 0.0001 millimeter to 5 millimeter.

Moreover, and as will be explained in greater detail below, it is furthermore preferred that the rotor is at least partially and preferably entirely received in the coil. In other words, it is preferred that the coil is at least partially and preferably entirely wrapped around the rotor. A shape of the rotor preferably corresponds to a shape of the coil. That is, it is preferred that the rotor has an ellipsoid shape, particularly preferably a spherical shape. In addition, the rotor is preferably rotatable with respect to the coil. In other words, the rotor can rotate or spin within the coil. A major advantage of the ellipsoidal rotor being received in the ellipsoidal coil is a greatly improved NMR filling factor and thus sensitivity in the NMR experiment.

In another aspect, a probe head for a probe of a magnetic resonance spectrometer is provided. The probe head comprises a rotor being configured to rotate about an axis of rotation, at least one rotation device being configured to generate a rotation of the rotor about the axis of rotation, and at least one coil. The rotation device comprises at least one fluid supply device that is configured to supply a fluid to the rotor. The coil is configured to transmit at least one radiofrequency signal in order to excite a sample being received in the rotor. Additionally or alternatively, the coil is configured to receive at least one radiofrequency signal being emitted by the sample in response to an excitation of the sample by a radio frequency signal. The rotation device further comprises at least one fluid directing device that is configured and/or arranged to direct the fluid being supplied by the fluid supply device to the rotor, and wherein the fluid directing device comprises or consists of the coil.

The coil can correspond to a coil as described previously. However, it should be noted that various types of coils as they are known in the state of the art could likewise be used. For instance, the coil could be a saddle coil, a Helmholtz coil, etc.

In any case, the probe head comprises a rotation device that comprises the coil. In other words, the coil is part of a stator, wherein the stator is understood as the mechanics that supply and affect a fluid flow being used to rotate a rotor. Current strategies for rotating rotors require a stator being arranged between the coil and the rotor comprising the sample. These apparatuses have disadvantages such as i) requiring precise design and fabrication of the stator cup and the fluid channel for supplying the fluid for stable spinning, ii) limit the use of inductors such as solenoid coils because of the stator geometry, iii) do not function well in cryogenic environments, and iv) are not durable due to damage caused by the rotating rotor to the softer stator cup. Imprecise design and fabrication, damages and bad behavior in cryogenic environments negatively affect the sensitivity of the NMR experiments. Besides, the high-precision requirement for the fabrication is associated with high costs. These disadvantages are overcome by the present probe head, wherein the capability of the rotor rotating or spinning within the coil releases the high-precision requirement, making it easier for the stator development of smaller rotors, and again greatly improves the NMR filling factor and thus the sensitivity.

The fluid directing device is particularly preferably configured and/or arranged such that a bearing force and/or a drive force rotating the rotor about the axis of rotation is generated.

The bearing force and the drive force are preferably generated by the fluid flowing through a gap between the rotor and the coil as will be explained in greater detail below. In this regard, it should be noted that an initial velocity of the rotor is preferably obtained from the fluid supply device.

As will be explained in greater detail below, the fluid supply device preferably comprises at least one fluid aperture for supplying the fluid to the rotor. However, it is likewise conceivable that the fluid supply device comprises two or more, in particular a plurality of fluid apertures for supplying the fluid to the rotor. Moreover, two or more fluid apertures are preferably arranged to provide rotation of the rotor about the axis of rotation. Additionally or alternatively, two or more fluid apertures are preferably arranged in at least one or one common plane.

In another aspect, a probe head for a magnetic resonance spectrometer is provided, wherein the probe head comprises a rotor being configured to rotate about an axis of rotation, at least one rotation device being configured to generate a rotation of the rotor about the axis of rotation, and at least one coil. The coil is configured to transmit at least one radiofrequency signal in order to excite a sample being received in the rotor. Additionally or alternatively, the coil is configured to receive at least one radiofrequency signal being emitted by the sample in response to an excitation of the sample by a radio frequency signal. The rotation device comprises at least one fluid supply device that is configured to supply a fluid to the rotor. The fluid supply device comprises a plurality of fluid apertures for supplying the fluid to the rotor. The plurality of fluid apertures are arranged to provide rotation of the rotor about the axis of rotation. Additionally or alternatively, the plurality of fluid apertures are arranged in at least one or one common plane.

The one or more common planes the fluid apertures are arranged in preferably runs or run perpendicularly to the rotation axis of the rotor.

The provision of a plurality of fluid apertures in at least one or exactly one common plane results in an overall fluid flow that provides an improved, in particular a higher, drive force to a surface of the rotor. A higher drive force leads to a higher spinning frequency or rotation frequency of the rotor about the axis of rotation during magic angle spinning, whereby the NMR sensitivity is improved.

In particular, the fluid apertures are preferably arranged and/or configured such, that a flow of the fluid is split into fluid streams, namely one fluid stream per fluid apertures. Moreover, the fluid apertures are arranged and/or configured such, that the individual fluid streams partially cancel out each other while summing up the drive force, leading to a balance control between the bearing force and the drive force.

Also in this case it is preferred that the probe head comprises a coil that corresponds to a coil as described previously. However, it should be noted that various types of coils as they are known in the state of the art could likewise be used.

The following explanations likewise apply to both of the above probe heads. In fact, the probe head comprising, inter alia, a rotation device comprising the fluid directing device that comprises or consists of the coil preferably comprises a fluid supply device comprising the plurality of fluid apertures being arranged in a common plane and vice versa. Any statements made herein with regard to one of the probe heads thus likewise apply to the other probe head. In particular, it should be noted that all aspects described herein can be present in a single probe head. For the sake of simplicity, reference is made in the following to a probe head.

The coil at least partially and particularly preferably entirely surrounds the rotor. That is, and as mentioned earlier, it is preferred that the rotor is at least partially and preferably entirely received in the coil. In other words, it is preferred that the coil is at least partially and preferably entirely wrapped around the rotor. Moreover, the rotor is preferably rotatable received within the coil and/or rotatable with respect to the coil.

A gap between the coil and the rotor is preferably 4 millimeter or smaller. Additionally or alternatively, a gap between the coil and the rotor is preferably between 50 micrometer and 4 millimeter, more preferably between 100 micrometer and 2 millimeter, and particularly preferably about 500 micrometer. Said gap can be understood as the spacing being formed between an inner surface of the turns of the coil facing towards an outer side of the rotor and the outer side of the rotor with respect to a direction running perpendicularly to the coil axis. Hence, the coil is tightly wrapped around the rotor, wherein a distance between a sample being received in the rotor and the coil is minimized. Thereby, the NMR filling factor and thus the sensitivity of the NMR experiments are further improved.

A shape of the rotor preferably corresponds to the shape of the coil. Additionally or alternatively, the rotor preferably comprises a sample chamber that is configured to receive a sample, and wherein a shape of the coil preferably corresponds to a shape of the sample chamber. Hence, the rotor preferably has an ellipsoidal shape, particularly preferably a spherical shape. Moreover, the sample chamber preferably has a an ellipsoidal shape, particularly preferably a spherical shape. The provision of an ellipsoidal sample chamber increases the sample volume, whereby the NMR filling factor is again greatly improved.

The fluid supply device preferably comprises a receptacle, and wherein the coil is at least partially and preferably entirely arranged within said receptacle.

That is to say, the fluid supply device is preferably arranged external to the coil. Additionally or alternatively, the coil is preferably at least partially and particularly preferably entirely arranged within the fluid supply device.

The receptacle particularly preferably corresponds to a through-hole extending through the fluid supply device. In other words, the coil is preferably not received in a stator cup or the like.

It is furthermore preferred that the coil is positioned in a center region of the fluid supply device to ensure stable spinning of the rotor. Said center region of the fluid supply device preferably corresponds to a geometrical center of the fluid flows or a geometrical center of the fluid apertures, respectively. The geometrical center of the fluid flows or of the fluid apertures is preferably arranged within the common plane the fluid apertures are arranged in, see above. In this way, a balanced fluid pressure can be applied onto the rotor.

Since the coil preferably at least partially surrounds the rotor, it is furthermore preferred that the rotor is at least partially and preferably entirely received in the fluid supply device, in particular in the receptacle of the fluid supply device, as well. Hence, the rotor is preferably arranged within the coil, which in turn is preferably arranged within the fluid supply device.

The one or more fluid apertures, in particular the plurality of fluid apertures, is preferably arranged in a region of the receptacle. In fact, it is preferred that the fluid aperture(s) are arranged such that they are facing towards and particularly preferably into the receptacle and as such towards the coil and the rotor being arranged within the receptacle. Various designs of the fluid apertures are conceivable. For instance, they can be arranged flush with a surface of the fluid supply device that delimits the receptacle. Alternatively, they can be protruding from the surface of the fluid supply device that delimits the receptacle.

Furthermore, they can be arranged at an angle with respect to the surface of the fluid supply device delimiting the receptacle and/or with respect to an outer surface of the rotor. To this end it is preferred that an aperture direction of the fluid apertures is tangential to an outer surface of the rotor.

The plurality of the fluid apertures is preferably arranged at least partially and particularly preferably entirely along a circumferential direction of the receptacle. Additionally or alternatively, the plurality of fluid apertures is preferably arranged at least partially and particularly preferably entirely along a circumferential direction of the coil. For instance, in the event of a spherical coil, it is preferred that the plurality of fluid apertures are arranged equatorially about the coil.

The arrangement of the fluid apertures preferably matches the shape of the rotor and/or the shape of the coil when seen in cross-section. For instance, in the event of a spherical coil having a spherical cross-section, the cross-section of the receptacle of the fluid supply device preferably has a circular shape and the arrangement of the fluid apertures is preferably circular as well.

The circumferential direction of the receptacle and/or the circumferential direction of the coil preferably run about an axis that extends perpendicularly to the coil axis. However, it should be noted that other arrangements are likewise conceivable. In particular, and as mentioned further below, the coil axis can be at any direction on a plane being perpendicular to a direction of a static magnetic field of a magnetic resonance spectrometer when the probe head is received in the magnetic resonance spectrometer, i.e. on a plane being the x,y-plane running perpendicularly to the z-axis if one is defining the z-axis as the direction of the external magnetic field as the z-axis as it is common in the field of NMR.

The fluid supply device is preferably configured to adjust the axis of rotation of the rotor relative to an adjustment axis of the probe head. Additionally or alternatively, the fluid supply device is preferably configured to adjust the axis of rotation of the rotor relative to a direction of a static magnetic field of a magnetic resonance spectrometer when the probe head is received in the magnetic resonance spectrometer.

That is to say, the fluid supply device can be seen as an adjustment device that is configured to adjust the axis of rotation of the rotor relative to the adjustment axis of the probe head or relative to the direction of the static magnetic field. The adjustment axis of the probe head preferably runs parallel to a direction of the static magnetic field of the magnetic resonance spectrometer when the probe head is received in the magnetic resonance spectrometer. Hence, the fluid supply device can be used to find the so-called magic angle.

The coil is preferably configured stationary during an adjustment by the fluid supply device with respect to the probe head. Additionally or alternatively, the fluid supply device is preferably configured movable during an adjustment with respect to the probe head.

The fluid supply device preferably adjusts the axis of rotation of the rotor in a nonmechanical manner.

In fact, it is preferred that there is no physical connection between the rotor and the fluid supply device. Instead, it is preferred that the axis of rotation of the rotor is perpendicular to the one or more common planes the fluid apertures are arranged in, and wherein a movement such as a rotation of the fluid supply device changes a flow direction of the fluid being supplied by the fluid supply device, whereby the rotor is reoriented to rotate or spin at an axis perpendicular to the fluid supply device. In another words, it is preferred that no mechanical adjustment is established between the fluid supply device and the rotor, but that the fluid supply device is adjusted mechanically.

Moreover, the fluid supply device is preferably arranged movable, in particular pivotable, in the probe head. During an adjustment by the fluid supply device it is particularly preferred that an orientation of the fluid supply device with respect to the probe head is adjusted as well, for instance by rotating the fluid supply device, whereby the axis of rotation of the rotor is adjusted as well.

In addition, it is preferred that the fluid directing device, in particular the coil, remains stationary during an adjustment by the fluid supply device. For instance, the coil stays static while the fluid supply device is rotated to adjust the axis of rotation of the rotor. It is furthermore preferred that the fluid directing device, in particular the coil, is arranged immovable, i.e. stationary, in the probe head.

As mentioned earlier, the coil preferably defines a coil axis. In the probe head, said coil axis preferably runs perpendicularly to an adjustment axis A of the probe head. Additionally or alternatively, said coil axis preferably runs perpendicularly to a direction of a static magnetic field B of a magnetic resonance spectrometer when the probe head is received in the magnetic resonance spectrometer. Additionally or alternatively, said coil axis preferably runs within a plane extending perpendicularly to the adjustment axis A of the probe head and/or perpendicularly to the direction of a static magnetic field B of a magnetic resonance spectrometer when the probe head is received in the magnetic resonance spectrometer. Said plane can be seen as the x,y-plane being spanned by x- and y-axis running perpendicularly to the z-axis if one is defining the z-axis as the direction of the external magnetic field as the z-axis as it is common in the field of NMR.

As mentioned earlier, all of the above aspects can be present in a single probe head. That is, a preferred probe head comprises an ellipsoidal rotor being surrounded by an ellipsoidal coil, wherein said coil in turn is part of or provides the fluid directing device of the rotation device. The rotation device preferably furthermore comprises the fluid supply device that comprises a plurality of fluid apertures being arranged in a common plane, and wherein the coil is surrounded by the fluid supply device.

### BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,
- Fig. 1: shows a perspective view of an NMR probe head comprising a rotation device and a rotor, wherein the rotation device comprises a fluid supply device and a fluid directing device;
- Fig. 2: shows a side view of the NMR probe head according to figure 1;
- Fig. 3: shows a front view of the fluid supply device and the rotor of the NMR probe head according to figure 1;
- Fig. 4: shows a side view of the fluid supply device and the rotor of the NMR probe head according to figure 1;
- Fig. 5a: shows a front view of a spherical coil being wound around a spherical rotor;
- Fig. 5b: shows a high frequency finite element simulation for the spherical coil being wound around the spherical rotor according to figure 5a;
- Fig. 6a: shows a front view of a cylindrical coil being wound around a cylindrical rotor known from the state of the art;
- Fig. 6b: shows a high frequency finite element simulation for the cylindrical coil being wound around the cylindrical rotor according to figure 6a;
- Fig. 7a: shows a first embodiment of a rotor of an NMR probe head;
- Fig. 7b: shows a sectional view of the rotor according to figure 7b;
- Fig. 8a: shows a second embodiment of a rotor of an NMR probe head;
- Fig. 8b: shows a sectional view of the rotor according to figure 8a;
- Fig. 9a: shows a third embodiment of a rotor of an NMR probe head;
- Fig. 9b: shows a sectional view of the rotor according to figure 9a;
- Fig. 10a: shows ⁷⁹Br spectra of KBr within the rotors of figures 7a to 9b;
- Fig. 10b: shows an expansion view of the center peak in figure 10a.

### DESCRIPTION OF PREFERRED EMBODIMENTS

Various aspects of the invention are now illustrated in greater detail with respect to the figures.

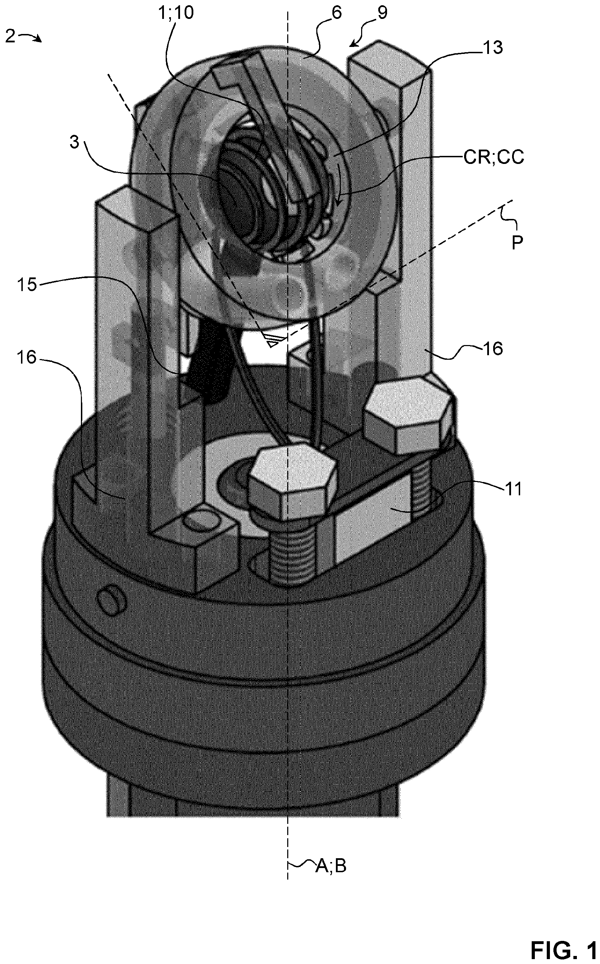

Figures 1 to 4 depict an NMR probe head 2 according to the invention, which comprises a rotor 3 being configured to rotate about an axis of rotation R, a rotation device 9 being configured to generate a rotation of the rotor 3 about the axis of rotation R, and a coil 1 being configured to transmit radiofrequency signals in order to excite a sample being received in the rotor 3 as well as to receive radiofrequency signals being emitted by the sample in response to its excitation by the radio frequency signal. The rotation device 9 comprises a fluid supply device 6 that is configured to supply a fluid to the rotor 3 and a fluid directing device 10 that is configured and arranged to direct the fluid being supplied by the fluid supply device 6 to the rotor 3.

In particular, in the depicted example, the probe head 2 is designed for a 9.5 mm spherical rotor 3 on a customized narrow-bore transmission line probe [21], but with the capability to be retrofit onto any kind of probes. Moreover, and as will be explained in greater detail below, the coil 1 in the depicted probe head 2 corresponds to a spherical solenoid coil wrapped tightly around a spherical rotor 3. The spherical solenoid coil 1 functions as an RF coil and keeps the rotor 3 position in the center of the fluid supply device 6, see figure 1. Additionally, the depicted probe head 2 comprises a capacitor 11 being used to tune and match an electric circuit of the entire probe. Thereby, an efficient transmission of correct RF signals is ensured.

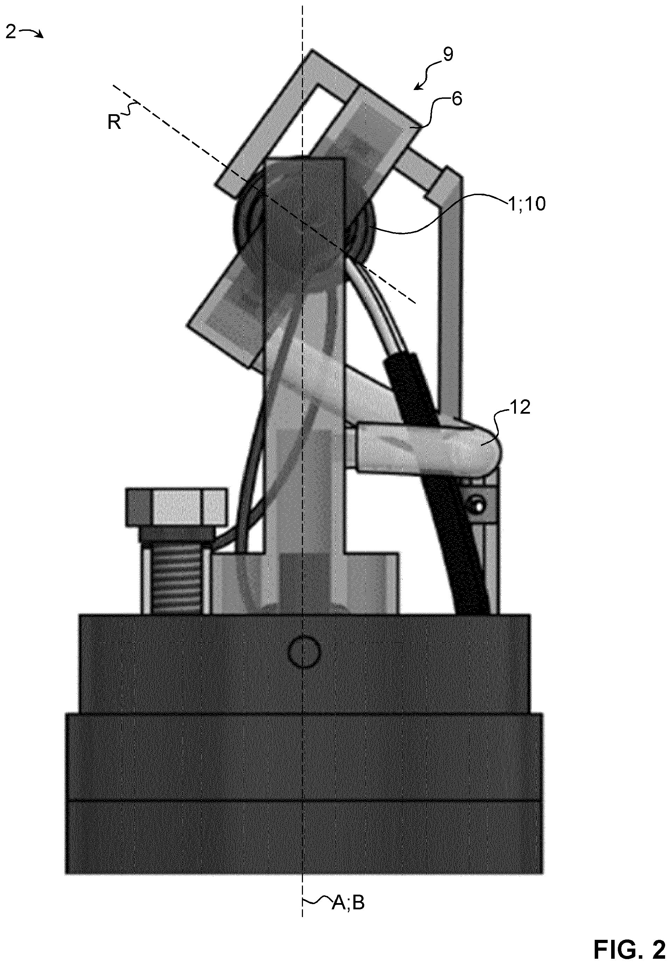

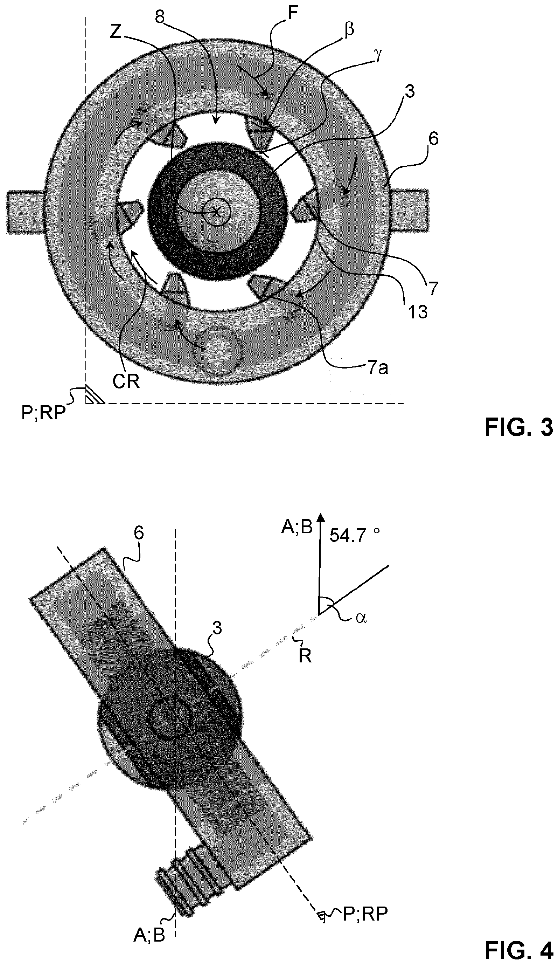

As mentioned earlier, the rotation device 9 comprises a fluid supply device 6 that is configured to supply a fluid to the rotor 3. As best seen in figures 3 and 4, the fluid supply device 6 comprises a receptacle 8 in the form of a through-hole extending through the fluid supply device 6, and wherein the coil 1 and the rotor 3 are arranged within said receptacle 8. That is to say, and as readily follows from figures 1 to 4, the fluid supply device 6 is arranged external to the coil 1. In fact, in the depicted example, the fluid supply device 6 has the shape of a ring, within which the coil 1 and the rotor 3 are arranged. As such, the fluid supply device 6 can be referred to as a ring stator. In addition, in the depicted example a gas tube 12 made from rubber is used to deliver the fluid being used to rotate the rotor 3 into the ring stator 6, while maintaining the rotation flexibility of the ring stator 6 for magic angle adjustment, see figures 1 and 2 and additional explanations provided further below. Said fluid corresponds to gas, which can be referred to as spinning gas.

Furthermore, the fluid supply device 6 comprises a plurality of fluid apertures 7, 7a, ... for supplying the fluid to the rotor 3, and wherein the plurality of fluid apertures 7, 7a, ... are arranged in a common plane P. In particular, the fluid apertures 7, 7a, ... are arranged and configured such, that a flow of the fluid is split into fluid streams, namely one fluid stream per fluid aperture 7, 7a, ..., which corresponds here to six streams flowing out of six fluid apertures 7, 7a, .... The fluid apertures 7, 7a, ... are arranged in a region of the receptacle 8. In fact, the fluid apertures 7, 7a, ... are arranged such that they are facing into the receptacle 8 and towards the coil 1 as well as the rotor 3 being arranged within the receptacle 8. Moreover, in the depicted example, the fluid apertures 7, 7a, ... are protruding from a surface 13 of the fluid supply device 6 that delimits the receptacle 8. Furthermore, the fluid apertures 7, 7a, ... are arranged at an angle β with respect to the surface 13 of the fluid supply device 6 delimiting the receptacle 8 and also at an angle γ with respect to an outer surface 14 of the rotor 3. Here, the fluid apertures 7, 7a, ... are arranged at an angle γ of 22° with respect to the outer surface 14 of the rotor 3. In figure 3, a flow direction F of the spinning gas is indicated with the arrows. The splitting of the spinning gas into different gas streams by the ring stator 6 is different from the stator with the semispherical stator cup to supply a single gas stream known from the state of the art [18-21]. Both kinds of stators known from the prior art lack individual control of the bearing and drive forces, but the six gas streams from the ring stator 6 according to the invention and flowing toward the rotor 3 can partially cancel out each other and sum up the drive force, leading to a balance control between the bearing and drive forces. In addition, spinning of spherical rotors 3 within the coil 1 according to the invention releases the requirement for high-precision 3D printing, which was essential for the previous stator designs with a semispherical cup. When stable spinning is established, the spherical rotor 3 spins around a center axis Z that is perpendicular to the ring stator 6. A spinning frequency of the spherical rotor 3 can be measured using fiber optics.

Moreover, in the depicted example, the fluid apertures 7, 7a, ... of the fluid supply device are arranged entirely along a circumferential direction CR of the receptacle 8 as well as entirely along a circumferential direction CC of the coil 1. Said circumferential direction CR of the receptacle 8 and said circumferential direction CC of the coil 1 run in each case about an axis that extends perpendicularly to a coil axis C of the coil 1, which corresponds here to the center axis Z. In particular, said circumferential directions CR, CC run within a ring plane RP of the fluid supply device 6 in the form of the ring stator. Said ring plane RP in turn runs parallel to the common plane within which the fluid apertures 7, 7a, ... are arranged.

The fluid supply device 6 is arranged movable, in particular pivotable, in the probe head 2. To this end, the fluid supply device 6 is pivotally mounted on two rods 16 that allow the fluid supply device 6 to pivot within the probe head 2. Moreover, the fluid supply device 6 is configured to adjust the axis of rotation R of the rotor 3 relative to an adjustment axis A of the probe head 2 as well as relative to a direction of a static magnetic field B of a magnetic resonance spectrometer when the probe head 2 is received in the magnetic resonance spectrometer. As indicated in figure 4, the adjustment axis A of the probe head 2 runs parallel to the direction of the static magnetic field B of the magnetic resonance spectrometer when the probe head 2 is received in the magnetic resonance spectrometer. Hence, the fluid supply device 6 can be used to adjust the axis of rotation R of the rotor 3 to the so-called magic angle α of 54.7°, see figure 4. Hence, the magic angle α can be adjusted by a mechanical movement such as a pivoting or rotation of the ring stator 6 through the rods 16 being connected to the ring stator 6. During the magic angle adjustment, the coil 1 stays static while the axis of rotation R of the rotor 3 tunes with the movement of the ring stator 6.

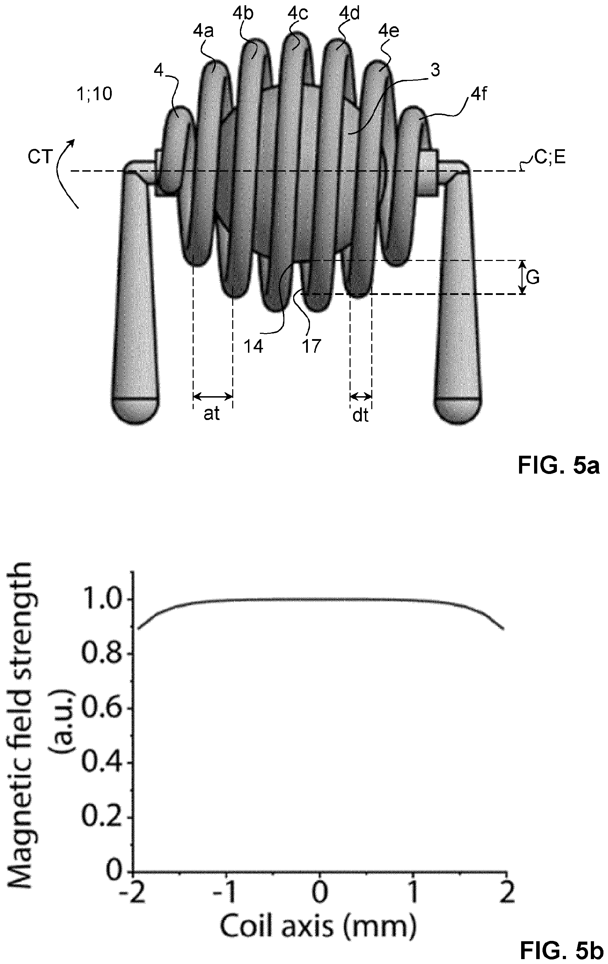

As follows from figure 1 and figure 5a, the coil 1 according to the invention comprises a plurality of turns 4, 4a, ... that are arranged along a coil axis C extending along the coil 1. In the probe head 2, said coil axis C runs perpendicularly to the adjustment axis A of the probe head 2 as well as to the direction of the static magnetic field B of a magnetic resonance spectrometer when the probe head 2 is received in the magnetic resonance spectrometer. Moreover, said coil axis C runs within a plane extending perpendicularly to the adjustment axis A of the probe head 2 and the direction of a static magnetic field B.

As furthermore follows from figure 1 and 5a, the rotor 3 is entirely received in the coil 1. In other words, the coil 1 is entirely wrapped around the rotor 3, and wherein the shape of the rotor 3 corresponds to the shape of the coil 1, i.e. both the rotor 3 as well as the coil 1 are spherical. In addition, the coil 1 is tightly wrapped around the rotor 3, wherein gap G between the coil 1 and the rotor is 4 millimeter or smaller. Said gap G corresponds to a spacing being formed between an inner surface 17 of the turns 4, 4a, ... of the coil 1 facing towards the outer surface 14 of the rotor 3 and said outer surface 14 of the rotor 3 with respect to a direction running perpendicularly to the coil axis C.

As mentioned initially, the coil 1 according to the invention not only serves the purpose of transmitting and receiving radiofrequency signals, but also constitutes a fluid directing device 10 that is configured and arranged to direct the fluid being supplied by the fluid supply device 6 to the rotor 3. To this end the coil is configured and arranged such, that is generates a bearing force and a drive force that rotates the rotor 3 about its axis of rotation R. Said bearing and drive forces are generated by the fluid being supplied by the fluid supply device 6 and that flows through the gap G being formed between the rotor 3 and the coil 1.

Aspects of a coil 1 according to the invention shall now be explained in greater detail. That is, and as follows from figure 5a, the plurality of turns 4, 4a, .... of the coil 1 define an ellipsoid shape, in the depicted example a spherical shape.

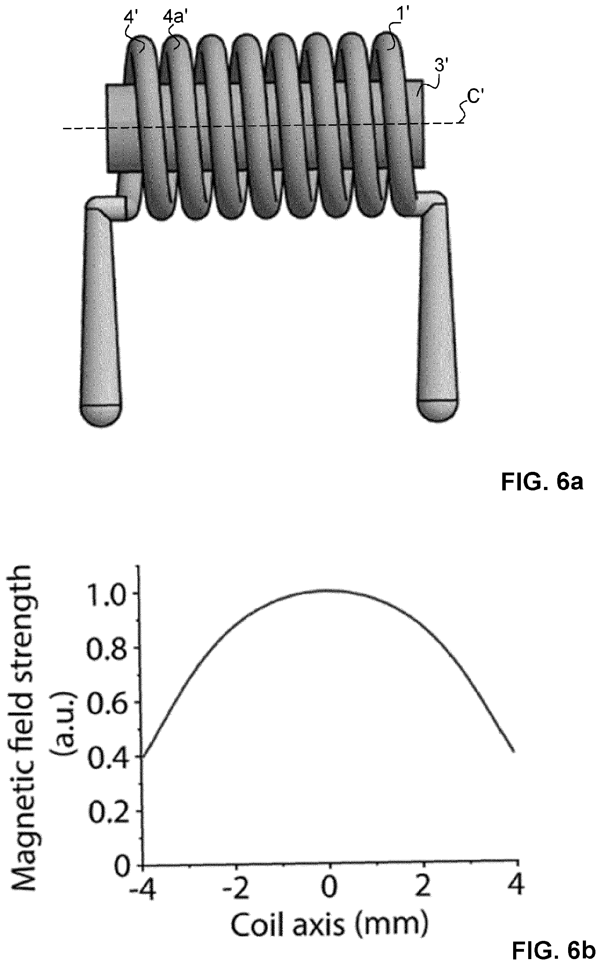

As further follows from figure 5a, the circumference of the individual turns 4, 4a, ... of the coil 1 with respect to a circumferential direction CT of the turns 4, 4a, ... is elliptic, in the depicted example circular. Moreover, the circumference of the individual turns 4, 4a, ... with respect to the circumferential direction CT of the turns 4, 4a, ... varies with respect to the coil axis C. With regard to an extension direction E, which extends from a beginning of the coil 1 being provided by a first turn 4 of the coil 1 to an end of the coil 1 being provided by a last turn 4f of the coil 1, the circumference of the turns 4, 4a, ... becomes increasingly larger and then increasingly smaller. Hence, the circumference of the turns 4, 4a, ... in the region of the beginning of the coil 1 and the circumference of the turns 4e, 4f in the region of the end of the coil 1 is smaller than the circumference of the turns 4c, 4d in a middle region of the coil 1, and wherein the circumference of the turn or turns 4c, 4d in the middle region is largest. This is in contrast to the solution known from the prior art and depicted in figure 6a, wherein all turns 4', 4a', ... of the coil 1' have a same circumference. Moreover, in the coil 1 according to the invention and depicted in figure 5a, a distance at between successive turns 4, 4a, ... of the coil 1 remains constant with respect to the coil axis C. Furthermore, a diameter dt of the individual turns 4, 4a, ... of the coil 1 remain constant with respect to the coil axis C as well.

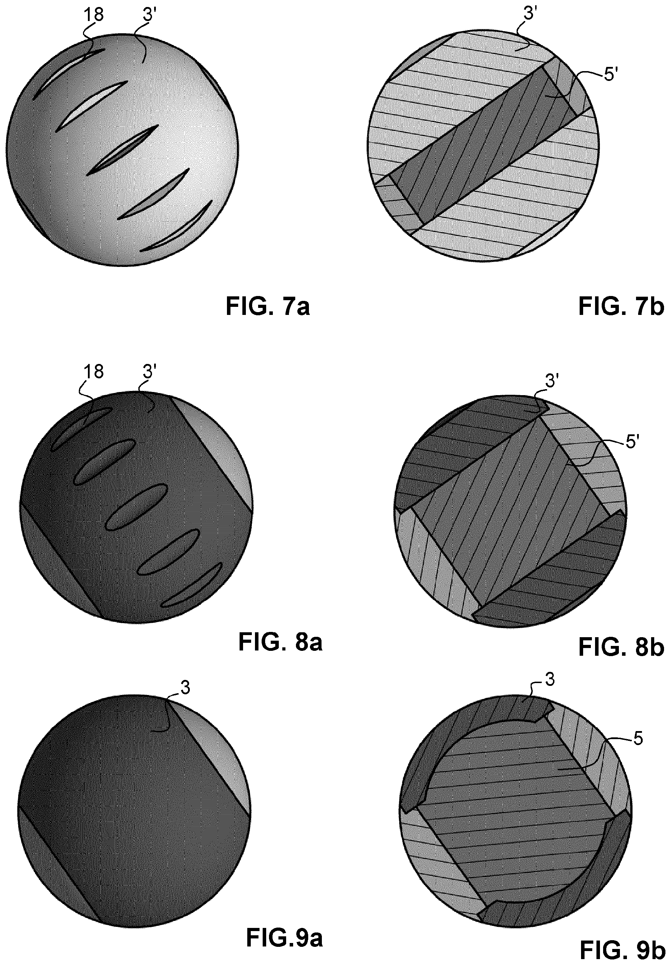

High frequency finite element simulation was carried out to compare the RF performance of the straight solenoid coil 1' with cylindrical rotors 3' known in the state of the art and the spherical solenoid coil 1 with spherical rotors 3 according to the invention. The simulation model includes a 3.9 millimeter diameter spherical rotor 3 and a 7-turn spherical solenoid coil 1, see figure 9a, and the magnetic field strength along the coil axis C is between 24.5 to 27.5 A/m within the spherical rotor 3, see figure 5b. Figure 6a depicts the comparison standard, which is here a 2.2 millimeter diameter commercial cylindrical rotor 3' with 30 microliter of sample volume and a 8-turn solenoid coil 1'. Figure 6b depicts the magnetic field strength along the coil axis, wherein the field strength is 36 A/m at the sample center and drops down to 15 A/m at the ends. For the straight solenoid coil 1' the field was down-scaled to count for the orientation along the magic angle. The 3.9 millimeter diameter spherical rotor 3 is used to keep the same sample volume as in the cylindrical rotor 3'. Moreover, the gaps G between coil 1,1' and sample in both simulations are kept the same, namely 0.6 millimeter. The number of turns 4, 4a, ...; 4', 4a', ... and wire diameter dt in each coil 1, 1' was optimized, see tables S1 and S2 below.

**Table S1. Simulation parameters and results for spherical solenoid coil, assuming a matched and tuned circuit with 5 mW input power in the coil.**

| Coil turns | Wire diameter (mm) | Magnetic field (A/m) | Impedance (Ohm) |
|---|---|---|---|
| 5 | 0.5 | 54.7 | 233.6 |
| 8 | 0.6 | 54.9 | 571.2 |
| 9 | 0.5 | 56.0 | 815.6 |
| 6 | 0.5 | 56.9 | 320.4 |
| 6 | 0.4 | 57.1 | 335.2 |
| 7 | 0.4 | 57.8 | 457.8 |
| 7 | 0.5 | 58.5 | 438.7 |
| 8 | 0.5 | 58.8 | 595.2 |
| 8 | 0.4 | 59.9 | 619.7 |
| 9 | 0.4 | 63.1 | 846.1 |

**Table S2. Simulation parameters and results for straight solenoid coil, assuming a matched and tuned circuit with 5 mW input power in the coil.**

| Coil length (mm) | Coil turns | Wire diameter (mm) | Magnetic field (A/m) | Impedance (Ohm) |
|---|---|---|---|---|
| 7.0 | 7 | 0.3 | 51.6 | 431.4 |
| 7.0 | 6 | 0.5 | 51.6 | 442.1 |
| 7.0 | 7 | 0.4 | 51.8 | 629.3 |
| 7.0 | 6 | 0.6 | 52.3 | 405.7 |
| 5.3 | 8 | 0.5 | 52.6 | 378.6 |
| 8.7 | 7 | 0.5 | 52.9 | 502.3 |
| 8.7 | 7 | 0.7 | 53.2 | 361.3 |
| 8.7 | 7 | 0.6 | 53.2 | 472.0 |
| 5.3 | 7 | 0.5 | 53.3 | 538.4 |
| 7.0 | 8 | 0.4 | 54.1 | 406.9 |
| 8.7 | 8 | 0.5 | 55.3 | 355.3 |
| 8.7 | 8 | 0.6 | 55.3 | 295.7 |
| 7.0^{a} | 7^{a} | 0.5^{a} | 55.5 | 285.0 |
| 7.0 | 8 | 0.5 | 55.6 | 452.6 |
| 7.0 | 7 | 0.7 | 55.8 | 315.5 |
| 8.7 | 8 | 0.7 | 55.9 | 381.3 |
| 7.0 | 7 | 0.6 | 56.1 | 334.5 |
| 7.0 | 8 | 0.6 | 57.3 | 267.2 |

| | | | | |
|---|---|---|---|---|
| ^{a} parameters from a solenoid coil on the Bruker 3.2 mm probe. | | | | |

An average magnetic field over the sample area was calculated, assuming a perfectly tuned and matched circuit with 5 mW RF input power. The highest magnetic field for the cylindrical rotor is 57.3 A/m with a 7 millimeter 8 turn coil and wire diameter of 0.6 mm, see table 1 below. The Bruker coil with 7 millimeter length, 7 turns and 0.5 millimeter wire diameter shows a slightly lower field. The spherical solenoid coil with the same winding and wire diameter shows a similar magnetic field as the straight solenoid coil. While the coil with 9 turns and 0.4 millimeter wire diameter shows a higher magnetic field of 63.1 A/m, the impedance is too high for matching the circuit. Although the average magnetic fields generated by both coils are similar, the homogeneity is much better within the spherical solenoid coil, see figure 5b. The straight solenoid coil shows a strong central field of 36 A/m, and drops to 15 A/m at the end of sample, see figure 6b.

**Table 1. coil parameters and simulation results**

| Coil | Coil length (mm) | turns | Wire diameter (mm) | Magnetic field (A/m) | Impedance (Ohm) |
|---|---|---|---|---|---|
| Straight solenoid | 7^{a} | 7 ^{a} | 0.5 ^{a} | 55.5 | 285.0 |
| | 7 | 8 | 0.6 | 57.3 | 267.2 |
| Spherical solenoid | - | 7 | 0.5 | 58.5 | 438.7 |
| | - | 9 | 0.4 | 63.1 | 846.1 |

| | | | | | |
|---|---|---|---|---|---|
| ^{a} parameters from a solenoid coil on the Bruker 3.2 mm probe. | | | | | |

From the simulation results, it is concluded that with the same sample volume, and sample-coil spacing, the spherical coil 1 according to the invention shows a comparable RF field to a straight solenoid coil 1' known from the state of the art, however with better homogeneity.

Furthermore, and as follows from figures 7a to 9b, the rotor 3, 3' comprises a sample chamber 5, 5' that is configured to receive a sample. The sample chamber 5, 5' can have various designs. For instance, it can be cylindrical as depicted in figures 7a to 8b or it can have an ellipsoidal shape, in particular a spherical shape as depicted in figures 9a and 9b. Most spherical rotors reported so far have been machined with a cylindrical sample chamber [18-21]. Although this design provides stable spinning due to the large moment of inertia from the thick rotor wall, it sacrifices sample volume and NMR filling factor.

Figures 7a and 7b depict a spherical rotor 3' (rotor a) in the form of a high-precision 9.525 mm diameter yttria-stabilized zirconia (ZrO₂) ball with a 2.54 mm diameter through hole and longitudinal turbine grooves that was purchased from O'Keefe Ceramics (Woodland Park, CO) and that is known from previous publications [18, 19, 22]. The rotor 3' comprises turbine grooves 18 in the form of twelve 60° notched grooves, and wherein the through hole delimits a sample chamber 5' that can only hold 39 microliter of sample. As is known, zirconia is a commonly used material for cylindrical rotors because it is less easy to crash. But this concern is not as substantial for spherical rotors, because with the spherical geometry the largest moment of inertia is always along the spinning axis [19]. Therefore, sapphire/ruby as the rotor material was further explored, considering their machining feasibility to obtain larger sample volume. Other advantages of sapphire/ruby include the high thermal conductivity and superior microwave transmission property, which are important for the application in dynamic nuclear polarization (DNP) NMR experiments. More importantly, the single crystal Al₂O₃ in sapphire/ruby is sensitive to the magic angle offset, allowing the magic angle adjust in situ [23].

Rotor b depicted in figures 8a and 8b is a high-precision 9.525 mm diameter ruby (99% Al₂O₃ + 1% Cr₂O₃) spherical rotor 3' with a 5.08 mm diameter through hole that was purchased from Saphirwerk AG (Brügg, Switzerland). It furthermore comprises twelve semispherical grooves 18 on the equator. Said grooves are 0.23 millimeter deep. The sample chamber 5' being formed by the through hole and with two flat-end caps defines a sample volume of 131 microliter.

Rotor c depicted in figures 9a and 9b is a high-precision 9.525 mm diameter ruby spherical rotor 3 according to the invention which is further hollowed out to limit a sample chamber 5 having a volume of 219 microliter. In particular, said sample chamber 5 is formed here by a through hole having a diameter of 5.08 millimeter and an additional spherical chamber of 7.5 millimeter. In other words, the shape of the sample chamber 5 corresponds to the shape of the rotor 3. The hollowed sample chamber 5 is machined using 5-axis milling technique (DMU 50, DMG MORI). Important to note here is that this rotor 3 has no turbine grooves for easier machining and more robust rotor shell as it is the case with the rotors depicted in figures 7a to 8b. It has been demonstrated that the spherical rotor without grooves have similar spinning frequency as other rotor designs [19].

The caps for all spherical rotors were 3D printed on Projet MJP 2500 (3D Systems) using ABS-like resin (VisiJet M2R-CL).

These three types of spherical rotors were packed with KBr powder to evaluate the probe head depicted in figures 1 to 4. The sample masses within rotor a, b, and c are 70.6 mg, 270.1 mg, and 405.3 mg, respectively. Rotor a and c were packed by compressing the sample using a rod that matches the hole diameter, whereas rotor b was packed tighter by sonication with force applied constantly onto the sample. Spherical solenoid coils 1 were hand-wrapped using 0.4 mm polyurethane/nylon-coated copper wire. A 3D printed mold was used as a coil wrapping guide. Both the ring stators 6 and the mold were 3D printed on Form 3 SLA 3D printers using clear v4 resin (Formlabs Inc., Somerville, MA). After the spherical rotor is loaded into the spherical coil 1, the coil position is adjusted such that the spherical rotor is in the center of the ring stator 6, rotating around an axis of rotation R being perpendicular to the ring stator 6. The axis of rotation 3 is then optimized by a mechanical rotation of the ring stator 6 to obtain the highest sideband intensities in the KBr spectra.

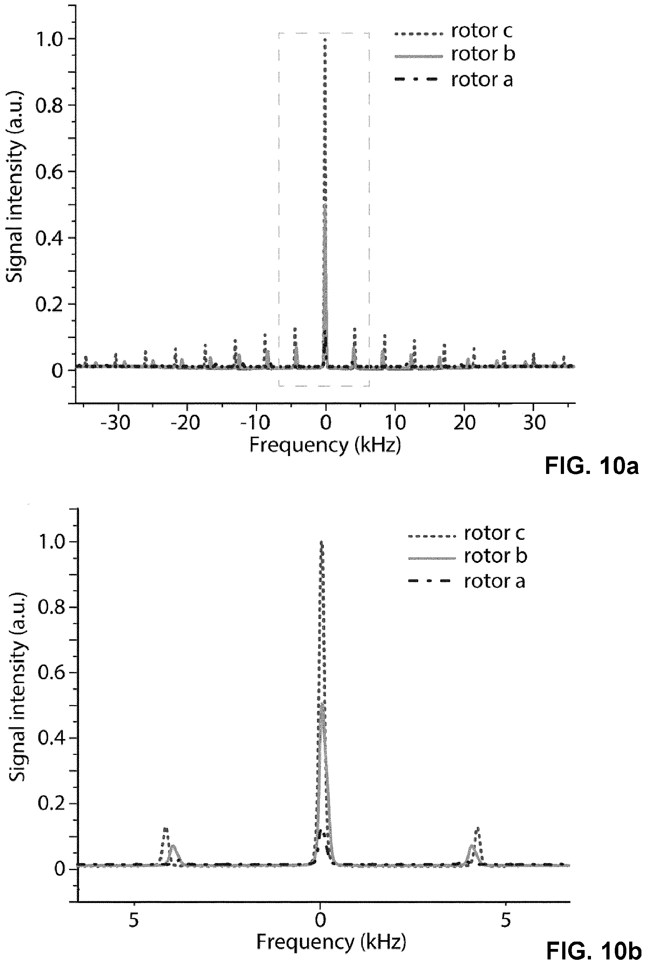

Figures 10a and 10b show the MAS spectra of 79Br of all three rotor types. All NMR experiments were performed at room temperature on a Bruker Avance 600 MHz spectrometer using a customized single-resonance, narrow-bore transmission line probe [21]. A Bloch decay pulse sequence with inter-scan delay of 1 s was used. 79Br spectra were obtained at 150.37 MHz using a π/2 pulse of 14 µs at 200 W incident RF power. The spinning frequency of ~ 4 kHz was maintained during the data acquisition with nitrogen gas at a pressure of 2 bar. Four scans are acquired in each spectrum. Note, the gradually inversed spinning sidebands at higher frequencies result from the long 90° pulse (14 microsecond), which excites only a limited frequency range efficiently. The highest NMR sensitivity is obtained with the rotor according to the invention, rotor c, which contains 405.3 mg of KBr, whereas the lowest sensitivity is from rotor a, with 70.6 mg of KBr, see the expansion view of the center peak of figure 10a depicted in figure 10b. The ratio of signal integration for each spectrum is 1:0.66: 0.15, similar to the ratio of sample mass within each rotor (1:0.67: 0.17). The most stable spinning was expected for the zirconia sphere (rotor a), because it has the thickest wall on the equator to provide a large moment of inertia. However, the inventors have surprisingly found out that the rotor according to the invention with a thin wall and no grooves (rotor c) also showed extremely stable spinning for hours. It turns out that the KBr powder within the rotor experienced a centrifugation force during the spinning, forming a hollowed space in the center. The redistribution of KBr sample within the rotor builds up a large moment of inertia for stable spinning.

Hence, the utility of a spherical coil tightly wrapped around the spherical rotor as an RF coil but also a part of the rotation device for MAS has been demonstrated. One unique advantage of this apparatus is that the coil axis C is fixed perpendicular to the external magnetic field B regardless of the axis of rotation R of the rotor 3. All the B1 field generated is along the x/y axis and experiments such as dynamic-angle spinning (DAS) and variable-angle spinning can be performed without compromising the B1 field. In other words, since the coil axis C is aligned perpendicular to the external magnetic field B, the present invention makes use of all the RF power and furthermore allows magic angle adjustment without coil movement. In addition, the capability of spherical rotor spinning within the RF coil 1 releases the high-precision requirement for stator fabrication, making it easier for the stator development of smaller rotors. Furthermore, the fluid supply device 6 in the form of the ring stator to supply spinning gas and to adjust the magic angle α being external to the coil 1 minimizes the gap G between the sample and coil 1. It has also been affirmed the NMR filling factor is greatly improved with the increased sample volume and minimized sample-coil distance. In particular, comparing to the spherical rotor with the cylindrical sample chamber, the hollowed spherical rotor leads to 6 times higher signal integration. In addition, the comparison of the NMR sensitivity between the spherical rotor and the commercial cylindrical rotor using the high frequency finite element simulation indicate similar B1 fields between the spherical rotor with spherical solenoid coil and the cylindrical rotor with straight solenoid coil.

### References

[1] Andrew, E. R., Bradbury, A. & Eades, R. G. Nuclear Magnetic Resonance Spectra from a Crystal Rotated at High Speed. Nature 182, 1659 (1958).
[2] Lowe, I. J. Free induction decays of rotating solids. Phys. Rev. Lett. 2, 285-287 (1959).
[3] Andrew, E. R. Magic angle spinning. Int. Rev. Phys. Chem. 1, 195-224 (1981).
[4] Schaefer, J. & Stejskal, E. O. Carbon-13 Nuclear Magnetic Resonance of Polymers Spinning at the Magic Angle. J. Am. Chem. Soc. 1031, 1031-1032 (1975).
[5] McDermott, A. Structure and Dynamics of Membrane Proteins by Magic Angle Spinning Solid-State NMR. Annu. Rev. Biophys. 38, 385-403 (2009).
[6] Bougault, C., Ayala, I., Vollmer, W., Simorre, J. & Schanda, P. Studying intact bacterial peptidoglycan by proton-detected NMR spectroscopy at 100 kHz MAS frequency ☆. J. Struct. Biol. 0-1 (2018) doi:10.1016/j.jsb.2018.07.009.
[7] Clauss, J., Schmidt-Rohr, K. & Spiess, H. W. Determination of domain sizes in heterogeneous polymers by solid-state NMR. Acta Polym. 44, 1-17 (1993).
[8] Trebosc, J., Wiench, J. W., Huh, S., Lin, V. S. & Pruski, M. Studies of Organically Functionalized Mesoporous Silicas Using Heteronuclear Solid-State Correlation NMR Spectroscopy under Fast Magic Angle Spinning. J. Ameican Chem. Soc. 127, 7587-7593 (2005).
[9] Lesage, A. et al. Polarization Transfer over the Water - Protein Interface in Solids **. Angew. Chemie 47, 5851-5854 (2008).
[10] Doty, F. D. & Ellis, P. D. Design of high speed cylindrical NMR sample spinners. Rev. Sci. Instrum. 52, 1868-1875 (1981).
[11] Knight, M. J. et al. Structure and backbone dynamics of a microcrystalline metalloprotein by solid-state NMR. Proc. Natl. Acad. Sci. U. S. A. 109, 11095-11100 (2012).
[12] Retel, J. S. et al. Structure of outer membrane protein G in lipid bilayers. Nat. Commun. 8, 1-10 (2017).
[13] Theint, T. et al. Species-dependent structural polymorphism of Y145Stop prion protein amyloid revealed by solid-state NMR spectroscopy. Nat. Commun. 8, (2017).
[14] Petkova, a. T. et al. Self-propagating, molecular-level polymorphism in Alzheimer's beta-amyloid fibrils. Science (80-. ). 307, 262-265 (2005).
[15] Kong, X. et al. Mapping of Functional Groups in Metal-Organic Frameworks. Science (80-. ). 341, 882-886 (2013).
[16] Wang, S. et al. Solid-state NMR spectroscopy structure determination of a lipid-embedded heptahelical membrane protein. Nat. Methods 10, 1007 (2013).
[17] Cegelski, L. et al. Rotational-Echo Double Resonance Characterization of the Effects of Vancomycin on Cell Wall Synthesis in Staphylococcus aureus †. Biochemistry 13053-13058 (2002) doi:10.1021/bi0202326.
[18] Chen, P. et al. Magic angle spinning spheres. Sci. Adv. 4, 1-8 (2018).
[19] Osborn Popp, T. M. et al. Highly stable magic angle spinning spherical rotors. Magn. Reson. 1, 97-103 (2020).
[20] Gao, C. et al. Four millimeter spherical rotors spinning at 28 kHz with double-saddle coils for cross polarization NMR. J. Magn. Reson. 303, 1-6 (2019).
[21] Chen, P.-H. et al. Two millimeter diameter spherical rotors spinning at 68 kHz for MAS NMR. J. Magn. Reson. Open 8-9, 100015 (2021).
[22] Popp, T. M. O. et al. Pneumatic angle adjustment for magic angle spinning spherical rotors. J. Magn. Reson. Open 6-7, 100014 (2021).
[23] Popp, T. M. O., Alaniva, N. H. & Barnes, A. B. Setting the Magic Angle Using Single Crystal Sapphire Rotors. J. Magn. Reson. Open 8-9, 100019 (2021).

**LIST OF REFERENCE SIGNS**

| | | | |
|---|---|---|---|
| 1 | coil | 18 | groove |
| 1' | coil | | |
| 2 | probe head | C | coil axis |
| 3 | rotor | CT | circumferential direction |
| 3' | rotor | CR | circumferential direction |
| 4, 4a, | turn | CC | circumferential direction |
| 4', 4a', | turn | Z | center axis |
| 5 | sample chamber | F | flow direction |
| 5' | sample chamber | E | extension direction |
| 6 | fluid supply device | A | adjustment axis |
| 7, 7a, | fluid aperture | R | axis of rotation |
| 8 | receptacle | B | direction of static magnetic field |
| 9 | rotation device | | |
| 10 | fluid directing device | P | plane |
| 11 | capacitor | RP | plane |
| 12 | tube | G | gap |
| 13 | surface | at | distance |
| 14 | surface | dt | diameter |
| 15 | fiber optics | α | magic angle |
| 16 | rod | β | angle |
| 17 | surface | γ | angle |

## Claims

1. A coil (1) for a probe head (2) of a magnetic resonance spectrometer comprising a rotor (3),
wherein the coil (1) is configured to transmit at least one radiofrequency signal in order to excite a sample being received in the rotor (3) and/or configured to receive at least one radiofrequency signal being emitted by the sample in response to its excitation by a radio frequency signal, and
wherein the coil (1) comprises a plurality of turns (4, 4a, ...) that are arranged along a coil axis (C) extending along the coil (1),
**characterized in that** the plurality of turns (4, 4a, ...) of the coil (1) define an ellipsoid shape, preferably a spherical shape.

2. The coil (1) according to claim 1, wherein a circumference of the individual turns (4, 4a, ...) with respect to a circumferential direction (CT) of the turns (4, 4a, ...) is elliptic, preferably circular, and/or
wherein a circumference of the individual turns (4, 4a, ...) with respect to a circumferential direction (CT) of the turns (4, 4a, ...) varies with respect to the coil axis (C).

3. The coil (1) according to any one of the preceding claims, wherein a distance (at) between successive turns (4, 4a, ...) of the coil (1) and/or a wire diameter (dt) of the individual turns (4, 4a, ...) of the coil (1) remains constant or varies with respect to the coil axis (C).

4. A probe head (2) for a probe of a magnetic resonance spectrometer comprising:
- a rotor (3) being configured to rotate about an axis of rotation (R);
- at least one rotation device (9) being configured to generate a rotation of the rotor (3) about the axis of rotation (R); and
- at least one coil (1), preferably as claimed in any one of the preceding claims,
wherein the rotation device (9) comprises at least one fluid supply device (6) that is configured to supply a fluid to the rotor (3),
wherein the coil (1) is configured to transmit at least one radiofrequency signal in order to excite a sample being received in the rotor (3) and/or configured to receive at least one radiofrequency signal being emitted by the sample in response to its excitation by a radio frequency signal,
**characterized in that** the rotation device (9) further comprises at least one fluid directing device (10) that is configured and/or arranged to direct the fluid being supplied by the fluid supply device (6) to the rotor (3), and
wherein the fluid directing device (10) comprises or consists of the coil (1).

5. The probe head (2) according to claim 4, wherein the fluid directing device (10) is configured and/or arranged such that a bearing force and/or a drive force rotating the rotor (3) about the axis of rotation (R) is generated.

6. The probe head (2) according to claim 4 or 5, wherein the fluid supply device (6) comprises at least one fluid aperture (7, 7a, ...) and preferably a plurality of fluid apertures (7, 7a, ...) for supplying the fluid to the rotor (3), and
wherein the plurality of fluid apertures (7, 7a, ...) preferably are arranged at least one of i) to provide rotation of the rotor (3) about the axis of rotation (R) or ii) in at least one common plane (P).

7. A probe head (2) for a magnetic resonance spectrometer comprising:
- a rotor (3) being configured to rotate about an axis of rotation (R);
- at least one rotation device (9) being configured to generate a rotation of the rotor (3) about the axis of rotation (R); and
- at least one coil (1), preferably as claimed in any one of claims 1 to 3;
wherein the rotation device (9) comprises at least one fluid supply device (6) that is configured to supply a fluid to the rotor (3),
wherein the coil (1) is configured to transmit at least one radiofrequency signal in order to excite a sample being received in the rotor (3) and/or configured to receive at least one radiofrequency signal being emitted by the sample in response to its excitation by a radio frequency signal,
**characterized in that** the fluid supply device (6) comprises a plurality of fluid apertures (7, 7a, ...) for supplying the fluid to the rotor (3), and
wherein the plurality of fluid apertures (7, 7a, ...) are arranged at least one of i) to provide rotation of the rotor (3) about the axis of rotation (R) or ii) in at least one common plane (P).

8. The probe head (2) according to any one of claims 4 to 7, wherein the coil (1) at least partially and particularly preferably entirely surrounds the rotor (3).

9. The probe head (2) according to claim 8, wherein a gap (G) between the coil (1) and the rotor (3) is 4 millimeter or smaller, and/or
wherein a gap (G) between the coil (1) and the rotor (3) is between 50 micrometer and 4 millimeter, preferably between 100 micrometer and 2 millimeter, particularly preferably about 500 micrometer.

10. The probe head (2) according to any one of claims 4 to 9, wherein a shape of the rotor (3) corresponds to the shape of the coil (1), and/or
wherein the rotor (3) comprises a sample chamber (5) that is configured to receive a sample, a shape of the coil (1) corresponding to a shape of the sample chamber (5).

11. The probe head (2) according to any one of claims 4 to 10, wherein the fluid supply device (6) comprises a receptacle (8), and wherein the coil (1) is at least partially and preferably entirely arranged within said receptacle (8).

12. The probe head (2) according to claim 11, wherein the at least one fluid aperture (7, 7a, ...) is arranged in a region of the receptacle (8), and/or
wherein a plurality of the fluid apertures (7, 7a, ...) are arranged at least partially and preferably entirely along a circumferential direction (CR) of the receptacle (8) and/or at least partially and preferably entirely along a circumferential direction (CC) of the coil (1).

13. The probe head (2) according to any one of claims 4 to 12, wherein the fluid supply device (6) is configured to adjust the axis of rotation (R) of the rotor (3) relative to an adjustment axis (A) of the probe head (2) and/or relative to a direction of a static magnetic field (B) of a magnetic resonance spectrometer when the probe head (2) is received in the magnetic resonance spectrometer.

14. The probe head (2) according to claim 13, wherein the coil (1) is configured stationary during an adjustment by the fluid supply device (6) with respect to the probe head (2), and/or
wherein the fluid supply device (6) is configured movable during an adjustment with respect to the probe head (2).

15. The probe head (2) according to any one of claims 4 to 14, wherein the coil (1) defines a coil axis (C), and wherein the coil axis (C) runs at least one of i) perpendicularly to an adjustment axis (A) of the probe head (2), ii) perpendicularly to a direction of a static magnetic field (B) of a magnetic resonance spectrometer when the probe head (2) is received in the magnetic resonance spectrometer, and iii) within a plane extending perpendicularly to at least one of the adjustment axis (A) of the probe head (2) and the direction of a static magnetic field (B) of a magnetic resonance spectrometer when the probe head (2) is received in the magnetic resonance spectrometer.
